# EUROPÄISCHE PATENTSCHRIFT

(11) **EP 0 740 499 B1**
(45) Veröffentlichungstag und Bekanntmachung des Hinweises auf die Patenterteilung: **20.12.2000**
(21) Anmeldenummer: 96106062.1
(22) Anmeldetag: 18.04.1996
(51) Int. Cl.: H05K 7/14, H02B 1/052

(54) **Befestigung einer Baugruppe an einer Hutschiene**
Rail mounting of an equipment
Fixation d'un appareillage sur un rail

(30) Priorität: 21.04.1995 DE 29506766 U
(43) Veröffentlichungstag der Anmeldung: 30.10.1996
(73) Patentinhaber: MAN Roland Druckmaschinen AG, 63075 Offenbach (DE)
(72) Erfinder: Tenfelde, Johannes, 63110 Rodgau (DE); Schlegel, Christian, 63128 Dietzenbach (DE)
(74) Vertreter: Stahl, Dietmar

(56) Entgegenhaltungen:
- EP-A- 0 547 618
- DE-A- 1 815 041
- DE-A- 3 922 551

## Beschreibung

Die Erfindung betrifft die Befestigung einer Baugruppen an einer Hutschiene gemäß dem Oberbegriff von Anspruch 1.

Aus EP-A-0 547 618 ist eine Haltevorrichtung für ein elektronisches Gerät mit einem Halteelement bekannt.

In Schaltschränken von Druckmaschinen ist es bekannt, elektronische Baugruppen, insbesondere Flachbaugruppen an sogenannten Hutschienen zu montieren. Die Hutschienen sind an der Rückwand bzw. an einem Rahmen des Schaltschrankes angebracht. Die Platine der Baugruppe weist dazu eine Hutschienen-Befestigung auf, vermittels der ein Aufstecken auf die beiden in einer Ebene liegenden Schenkel der Hutschiene möglich ist. Zusätzlich sind auch noch Verriegelungen vorgesehen, vermittels der die Baugruppe mit einer einfachen Handhabung von der Hutschiene wieder abgenommen werden kann. Elektronik-Baugruppen weisen häufig auch ein oder mehrere Kühlkörper auf, um die in bestimmten Bauelementen entstehende Verlustwärme an die Umgebungsluft abgeben zu können. Dazu sind die Kühlkörper großflächig ausgebildet und thermisch gut leitend mit den entsprechenden Bauelementen gekoppelt.

Nachteilig bei den bekannten Ausführungsformen von Hutschienen-Befestigungen elektronischer Baugruppen ist, das an der Platine selbst die Hutschienen-Befestigung angebracht ist. Um eine mechanisch große Festigkeit zu erzielen, muß die Hutschienen-Befestigung einen Mindestanteil der Platine umfassen, so daß dieser Raum nicht mehr für die Belegung mit elektronischen Bauelementen zur Verfügung steht. Nachteilig ist ferner, daß die Hutschienen-Befestigung als separates Bauteil vorzusehen ist.

Aufgabe der vorliegenden Erfindung ist es daher eine Hutschienen-Befestigung gemäß dem Oberbegriff von Anspruch 1 derartig weiterzubilden, so daß sich eine kostengünstige Ausführungsform ergibt.

Gelöst wird diese Aufgabe durch die kennzeichnenden Merkmale von Anspruch 1. Weiterbildungen der Erfindung ergeben sich aus den Unteransprüchen.

Gemäß der Erfindung ist vorgesehen, daß die Hutschienen-Befestigung direkt am Kühlkörper der Baugruppe angebracht ist, die Baugruppe also über den Kühlkörper an der Hutschiene befestigt wird. Die die elektronischen Bauelemente tragende Platine wird somit über den Kühlkörper getragen. Dadurch gibt sich bei einfacher Ausführungsform eine mechanisch sehr stabile Aufhängung, was insbesondere bei massiven Ausführungen von Kühlkörpern wünschenswert ist.

Des weiteren erfolgt die Erläuterung einer Ausführungsform der Erfindung anhand der Zeichnungen.

Es zeigt:
- Fig. 1: perspektivisch eine elektronische Baugruppe mit der erfindungsgemäßen Hutschienen-Befestigung, und
- Fig. 2: die Hutschienen-Befestigung in einer Seitenansicht.

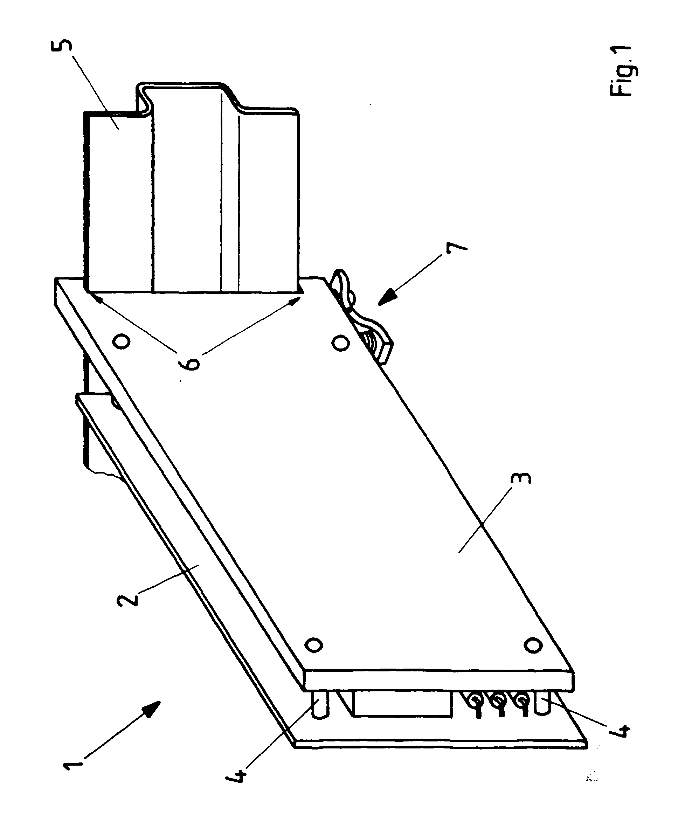

Wie in Fig. 1 dargestellt besteht eine elektronische Baugruppe 1 aus einer Platine 2 sowie einem parallel zur Ebene der Platine 2 flächig ausgebildet verlaufenen Kühlkörper 3. Es ist angedeutet, daß zwischen der Platine 2 sowie dem Kühlkörper 3 elektronische Bauelemente angeordnet sind. Nicht dargestellt ist in Fig. 1, daß einige der Bauelemente mit ihrer Oberseite in thermisch gutem Kontakt mit dem Kühlkörper 3 verbunden sind. Der Kühlkörper 3 ist zusätzlich mittels Stegen 4 mit der Platine 2 verbunden, so daß eine hohe mechanische Festigkeit der Baugruppe 1 gegeben ist.

Die zur Hutschiene 5 weisende Kante des Kühlkörpers 3 ist zu einer Befestigung 6 ausgebildet. An der Unterkante des Kühlkörpers 3 ist ferner eine manuell betätigbare Verriegelung 7 angebracht, vermittels der ein Aufstecken sowie ein Abnehmen der Baugruppe 1 an der Hutschiene 5 möglich ist.

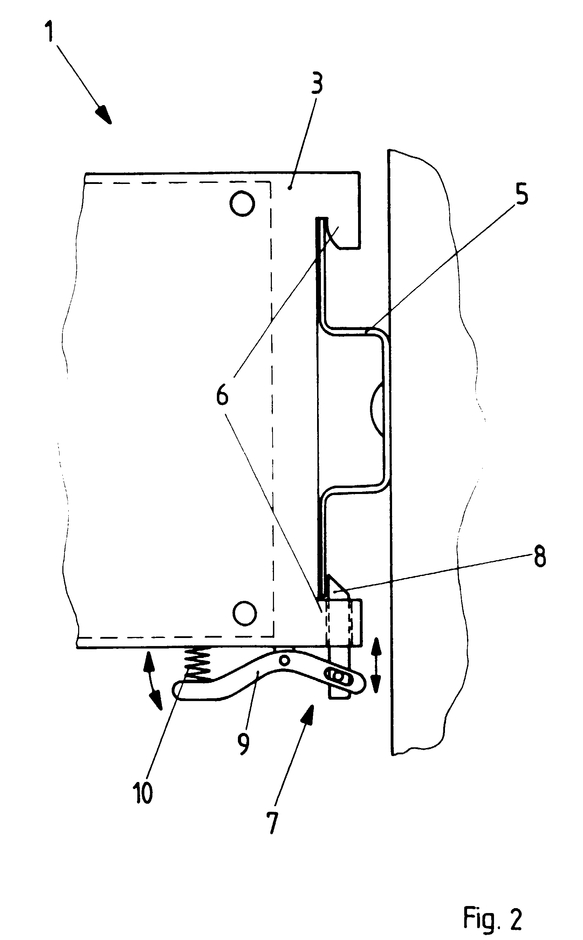

Fig. 2 zeigt eine Seitenansicht der erfindungsgemäß ausgebildeten Hutschienen-Befestigung. Dargestellt ist im Profil die an einer angedeuteten Rückwand eines Schaltschrankes angebrachte Hutschiene 5. Der teilweise dargestellte Kühlkörper 3 weist im eingebauten Zustand der Baugruppe 1 an seinem oberen Ende eine hakenförmigen, den oberen, senkrecht verlaufenden Schenkel der Hutschiene 5 hinterfassenden Bereich auf. Der untere Teil der Befestigung 6 besteht dabei aus einem senkrecht zum unteren, vertikal verlaufenen Schenkel der Hutschiene 5 ausgebildeten Vorsprung, der über eine Bohrung einen an seinem Ende keilförmig geformten Stift 8 linear beweglich aufnimmt. Das der Hutschiene 5 abgewandte Ende des Stiftes 8 ist an einem Schenkel einer Wippe 9 angelenkt, die ihrerseits eine Drehgelenk-Verbindung mit der unteren Kante des Kühlkörpers 3 aufweist. An dem anderen freien Schenkel der Wippe 9 ist eine Druckfeder 10 angeordnet, vermittels der über die Wippe 9 der Stift 8 in der Schließstellung gehalten wird. Stift 8, Wippe 9 und Druckfeder 10 bilden die Verriegelung 7 der Befestigung 6.

Zum Abnehmen der Baugruppe 1 von der Hutschiene 5 braucht lediglich die Wippe 9 betätigt zu werden, so daß durch diese Hebelanordnung der Stift 8 den Schenkel der Hutschiene 5 freigibt, so daß der untere Teil der Befestigung 6 mittels einer leichten Schwenkbewegung von der Hutschiene 5 entnommen werden kann. Zum Befestigen der Baugruppe 1 an der Hutschiene 5 wird zunächst der obere, hakenförmige und den Schenkel der Hutschiene 5 hintergreifende Teil des Kühlkörpers 3 auf die Hutschiene 5 eingehängt und sodann der untere Teil der Befestigung 6 gegen den unteren Schenkel der Hutschiene 5 gedrückt. Durch die keilförmige Ausbildung des Stiftes 8 wird dieser entgegen der Kraft der Feder 10 zurückgedrückt, so daß sich ein Einrasten nach Art eines Schnappverschlusses ergibt.

### Bezugszeichenliste

- 1: Baugruppe
- 2: Platine
- 3: Kühlkörper
- 4: Steg
- 5: Hutschiene
- 6: Befestigung
- 7: Verriegelung
- 8: Stift
- 9: Wippe
- 10: Feder

## Patentansprüche

1. Befestigung einer elektronischen Baugruppe an einer Hutschiene, insbesondere in Schaltschränken von Druckmaschinen, wobei die Baugruppe eine Bauelemente tragende Platine sowie einen Kühlkörper aufweist,
**dadurch gekennzeichnet,**
daß die Befestigung (6) für die Aufhängung an der Hutschiene (5) am Kühlkörper (3) der Baugruppe (1) angebracht ist.

2. Befestigung nach Anspruch 1,
**dadurch gekennzeichnet,**
daß die Befestigung (6) am Kühlkörper (3) eine manuell betätigbare Verriegelung (7) in Form eines linearbeweglich gelagerten Stiftes (8) mit einem keilförmig ausgebildeten Ende umfaßt.

3. Vorrichtung nach Anspruch 1 oder 2,
**dadurch gekennzeichnet,**
daß der Kühlkörper (3) mit der Befestigung (6) als ein parallel zur Platine (2) verlaufende, rechteckige Platte ausgebildet ist.

4. Befestigung nach einem der vorhergehenden Ansprüche,
**dadurch gekennzeichnet,**
daß die Platine (2) zusätzlich über Stege (4) mit dem Kühlkörper (3) verbunden ist.

## Claims

1. Fixing of an electronic module to a top hat rail, particularly in switch boxes of printing presses, wherein the top hat rail has a board carrying components as well as a cooling body, characterised in that the fixture (6) for suspending on the top hat rail (5) is fitted to the cooling body (3) of the module (1).

2. Fixing according to Claim 1, characterised in that the fixing (6) comprises on the cooling body (3) a manually actuatable latch (7) in the form of a linearly movably mounted post (8) with an end constructed in a wedge shape.

3. Fixing according to Claim 1 or 2, characterised in that the cooling body (3) with the fixing (6) is constructed as a rectangular plate running parallel to the board (2).

4. Fixing according to one of the preceding Claims, characterised in that the board (2) is additionally connected with the cooling body (3) via posts (4).

## Revendications

1. Fixation d'un appareillage électronique sur un profilé chapeau, en particulier dans des armoires de commande de machines d'impression, l'appareillage présentant une platine portant des éléments ainsi qu'un corps de refroidissement,
caractérisée en ce que la fixation (6), pour la suspension au profilé chapeau (5), est agencée sur le corps de refroidissement (3) de l'appareillage (1).

2. Fixation selon la revendication 1,
caractérisée en ce que la fixation (6) sur le corps de refroidissement (3) comporte un verrouillage (7) pouvant être actionné manuellement, sous forme d'une tige (8), montée de façon linéairement mobile, ayant une extrémité réalisée en forme de coin.

3. Dispositif selon la revendication 1 ou 2,
caractérisé en ce que le corps de refroidissement (3) avec la fixation (6) est réalisé comme une plaque rectangulaire s'étendant parallèlement à la platine (2).

4. Fixation selon une des revendications précédentes,
caractérisée en ce que la platine (2) est reliée de plus, par l'intermédiaire de chevilles (4), au corps de refroidissement (3).
